# EUROPEAN PATENT APPLICATION

(11) **EP 2 360 716 A1**
(43) Date of publication of application: **24.08.2011**
(21) Application number: 09827341.0
(22) Date of filing: 17.11.2009
(51) Int. Cl.: H01L 21/205, C23C 16/509, H01L 31/04

(54) **PLASMA PROCESSING APPARATUS**

(30) Priority: 20.11.2008 JP 2008297335
(71) Applicant: Evatech Co., Ltd., Kuze-gun Kyoto 613-0024 (JP)
(72) Inventor: INO, Eiji, Kuze-gun Kyoto 613-0024 (JP); WATANABE, Akira, Kuze-gun Kyoto 613-0024 (JP); ISHIHARA, Shunichi, Kuze-gun Kyoto 613-0024 (JP); ASHIDA, Hajime, Kuze-gun Kyoto 613-0024 (JP); SHOJI, Hiroshi, Kuze-gun Kyoto 613-0024 (JP); YOSHIMURA, Keiichi, Kuze-gun Kyoto 613-0024 (JP)
(74) Representative: Hehl, Ulrich
(86) International application number: PCT/JP2009/006168
(87) International publication number: WO 2010/058560

(57) **Abstract**

A plasma processing device 10 according to the present invention includes a plasma processing chamber 11 consisting of a vacuum container, a pair of substrate holders 12 standing opposite each other in the plasma processing chamber 11, a plurality of first reaction gas tubes 13 provided between the two substrate holders 12, and a plurality of second reaction gas tubes 14 provided between the plurality of first reaction gas tubes 13 and each of the two substrate holders 12. The first reaction gas tubes 13, which are made of an electrically conductive material, are electrically connected to a first radio-frequency power source 151 or second radio-frequency power source 152. The first reaction gas tubes 13 double as a radio-frequency antenna, while the second reaction gas tubes 14 double as an electrode.

## Description

### TECHNICAL FIELD

The present invention relates to a plasma processing device for generating plasma and performing deposition on a tabular substrate by using the plasma.

### BACKGROUND ART

Plasma processing devices are widely used for the production of solar cells, displays and other devices. For example, in the production of a silicon thin-film solar cell, an amorphous or crystalline silicon thin film is produced with a plasma processing device. As compared to the crystalline silicon thin film, the amorphous silicon thin film has the advantageous characteristic that it can achieve a higher level of output power since the photoelectric conversion occurs at shorter wavelengths. On the other hand, the crystalline silicon thin film has the advantage that it is more resistant to degradation than the amorphous silicon thin film. In the case where the crystalline silicon thin film is a microcrystalline type, the photoelectric conversion occurs within a wavelength band that is longer than but relatively close to the photoelectric conversion wavelength band of the amorphous silicon thin film. Accordingly, similar to the amorphous silicon thin film, the microcrystalline silicon thin film can be independently used in silicon thin-film solar cells. It may also be combined with the amorphous silicon thin film to form a broad photoelectric conversion wavelength band in a short-wavelength region. This combination is called a "tandem type."

As the plasma processing device for producing silicon thin films, capacitively coupled plasma processing devices, which are relatively inexpensive, have been most commonly used. In a capacitively coupled plasma processing device, a substrate is attached to one of a pair of parallel plate electrodes so that it faces the other electrode. In this state, a gas is introduced into the space between the parallel plate electrodes, and a voltage is applied between these electrodes to generate electric discharge, whereby the gas is decomposed into radicals or ions. These radicals or ions are combined together on the surface of the substrate, forming a thin film.

However, capacitively coupled plasma generation devices cannot produce a film having a large thickness since it is difficult for this type of device to generate high density plasma and thereby increase the deposition rate. Furthermore, since the crystal growth is slow, it is practically impossible to create a microcrystalline silicon thin film. Given these problems, an inductively coupled plasma processing device is used to produce a film having a large thickness or a crystalline silicon thin film. In the inductively coupled plasma processing device, a radio-frequency high current is passed through an antenna (coil), whereby a radio-frequency magnetic field and a radio-frequency electric field, which results from the temporal change in the magnetic field, are generated in the vicinity of the antenna. In the radio-frequency electric field, electrons are accelerated by receiving energy from the electric field. The accelerated electrons collide with the gas molecules, breaking them into fragments. Inductively coupled plasma processing devices can generate plasma with higher density than the plasma generated by capacitively coupled plasma processing devices. Therefore, it is possible to increase the deposition rate and the crystal-growth speed.

Patent Document 1 discloses a method for creating a pin-type thin-film solar cell having a layered structure of a p-type semiconductor layer (p-layer), intrinsic semiconductor layer (i-layer) and n-type semiconductor layer (n-layer), in which the p-layer and n-layer are formed with a capacitively coupled plasma processing device, i.e. the inexpensive type of device, while the i-layer, which is two or three orders of magnitudes thicker than the p-layer or n-layer and requires higher deposition rates, is formed with an inductively coupled plasma processing device.

However, in the inductively coupled plasma processing device, a large distance is required between the radio-frequency antenna and the substrate to create a uniform film. Therefore, the pressure must be decreased to 1 Pa or even lower levels to prevent second-order reaction of the radicals generated in the plasma. To achieve such a low pressure, it is necessary to provide an extremely large evacuation system or decrease the amount of introduced gas to extremely low levels. In any case, the production cost of the film will significantly increase.

Patent Document 2 discloses an inductively coupled plasma processing device including a deposition chamber (vacuum chamber) in which a sample stage is provided, a plasma-generating chamber separated from the deposition chamber by a first electrode having an orifice, an antenna provided in the plasma-generating chamber, and a second electrode facing the first electrode across the plasma-generating chamber. In this inductively coupled plasma processing device, after a gas is introduced into the plasma-generating chamber, a radio-frequency power is supplied to the antenna to generate plasma. A bias voltage is applied between the first and second electrodes to accelerate ions in the plasma by an electric field between the first and second electrodes and pass them through the orifice of the first electrode into the vacuum chamber. The ions introduced in this chamber collide with the substrate in a manner similar to the case of the capacitively coupled plasma processing device. Therefore, a high-uniformity film can be obtained.

### BACKGROUND ART DOCUMENT

### PATENT DOCUMENT

Patent Document 1: JP-A 2001-291882 (Paragraph [0048])
Patent Document 2: JP-A 2004-281230 (Paragraphs [0022]-[0030], [0077]-[0079] and Fig. 10)

### DISCLOSURE OF THE INVENTION

### PROBLEM TO BE SOLVED BY THE INVENTION

The inductively coupled plasma processing device can more efficiently decompose gas molecules than the capacitively coupled plasma processing device. However, this characteristic may also cause unfavorable second-order reactions, such as an excessive decomposition of the gas molecules or an unexpected combination of one radical with another ion or radical. These reactions may possibly produce unwanted ions or radicals. For example, when the silane-gas molecule (SiH₄) is decomposed, SiH₃, SiH₂, SiH and Si (each being either a radical or ion) are successively produced in this order, among which the SiH₃ radical is known to be most suitable for creating a high-quality silicon thin film. An excessive decomposition of the ions or radicals causes a decrease in the amount of the SiH₃ radical, along with an increase in unwanted radicals of SiH₂, SiH or Si. These unwanted radicals may deposit on the surface of the substrate and deteriorate the quality of the silicon thin film.

In the device disclosed in Patent Document 2, when the bias voltage is applied, the electric field for accelerating the ions is formed over the entirety of the plasma-generating chamber. Accordingly, not only an ion having an intended amount of energy but also an excessively accelerated ion is created. As a result, ions having excessive amounts of energy impinge on the surface of the substrate, whereby the atomic arrangement of the film is disordered and a defect is formed. The ions can contribute to the formation of a crystalline film with satisfactory qualities if they collide with the substrate at appropriate speeds and thereby increase the surface temperature of the film and help the rearrangement of the atoms on the film surface. Accordingly, supplying the ions with an appropriately controlled amount of energy onto the substrate is essential to create a high-quality crystalline film while maintaining the substrate temperature at low levels.

The problem to be solved by the present invention is to provide an inductively coupled plasma processing device capable of preventing excessively decomposed radicals or ions from impinging on the surface of the substrate. The present invention also provides an inductively coupled plasma processing device capable of appropriately accelerating a desired kind of ions in the plasma so as to improve the properties of the film by an ion-assist effect on the surface of the substrate.

### MEANS FOR SOLVING THE PROBLEMS

A plasma processing device according to the first aspect of the present invention aimed at solving the aforementioned problems includes:
a) a plasma processing chamber;
b) a substrate holder provided in the plasma processing chamber;
c) a radio-frequency antenna located apart from the substrate holder within the plasma processing chamber;
d) an electrode located between the radio-frequency antenna and the substrate holder, the electrode being capable of allowing a passage of plasma;
e) a voltage-applying means for applying a voltage between the electrode and the substrate holder;
f) a first reaction gas supply port for supplying a first reaction gas to a space on one side of the electrode where the radio-frequency antenna is located; and
g) a second reaction gas supply port for supplying a second reaction gas into a space between the electrode and the substrate holder.

In the plasma processing device according to the first aspect of the present invention, the first and second reaction gases are supplied from two separate gas-supply ports into the plasma processing chamber. The first reaction gas is supplied from the first reaction gas supply port to a position closer to the radio-frequency antenna than the position where the second reaction gas is supplied. Therefore, the first reaction gas is decomposed by the electric field created in the vicinity of the ratio-frequency antenna, whereby high-density plasma is generated. On the other hand, the second reaction gas is supplied from the second reaction gas supply port into the space between the electrode and the substrate holder, where this gas is decomposed, mainly in the vicinity of the second reaction gas supply port, by coming in contact with the plasma generated from the first reaction gas, or more specifically, by reacting with a radical formed from the first reaction gas. As a result, a radical of the second reaction gas, which contributes to the deposition of the film, is formed. Since the space between the electrode and the substrate holder, into which the second reaction gas is supplied, is located apart from the radio-frequency antenna, the generated second reaction gas will not be excessively decomposed by the electric field from the radio-frequency antenna, so that a desired kind of radical is obtained.

Furthermore, in the plasma processing device according to the first aspect of the present invention, an electrode is provided between the radio-frequency antenna and the substrate holder, and a voltage (bias voltage) can be applied between the electrode and the substrate holder so that ions with desired amounts of energy will be made to impinge on the surface of the substrate held by the substrate holder. Such an ion causes an ion-assisted surface diffusion on the surface of the substrate and thereby contributes to improving the film properties. There is a possibility that a small amount of unwanted radicals or ions are produced from a portion of the second reaction gas diffusing within the plasma processing device and flowing into the vicinity of the radio-frequency antenna. However, this diffusion of the second reaction gas into the vicinity of the radio-frequency antenna can be prevented by setting the pressure at the first reaction gas supply port to be higher than the pressure at the second reaction gas supply port. The use of the electrode being capable of allowing the passage of plasma is aimed at helping the radical of the first reaction gas produced in the vicinity of the radio-frequency antenna and the plasma containing ions controlled by the bias voltage of the electrode to reach the side where the substrate holder is located. For example, a grid-shaped electrode or an electrically conductive plate with one or more holes can be used as the aforementioned electrode. The voltage-applying means may apply either a DC voltage or an AC voltage.

In a desirable mode of the present invention, the aforementioned electrode is an array of electrically conductive second reaction gas tubes through which the second reaction gas can be passed, and the second reaction gas supply port is a hole formed in the second reaction gas tube. Making the second reaction gas tube double as the electrode in this manner is advantageous for simplifying the device structure. In the present mode, the plasma generated in the vicinity of the radio-frequency antenna passes through the interspaces of the second reaction gas tubes.

A plasma processing device according to the second aspect of the present invention aimed at solving the previously described problems includes:
a) a plasma processing chamber;
b) a substrate holder provided in the plasma processing chamber;
c) a radio-frequency antenna located apart from the substrate holder within the plasma processing chamber;
d) a first reaction gas supply port for supplying a first reaction gas to a space in a vicinity of the radio-frequency antenna; and
e) a second reaction gas supply port for supplying a second reaction gas to a space closer to the substrate holder than the aforementioned space in the vicinity of the radio-frequency antenna.

The strength of the radio-frequency electromagnetic field rapidly decreases as the distance from the radio-frequency antenna increases. For example, when a radio-frequency power of 1 kW to several kW is supplied to the radio-frequency antenna, the largest portion of the plasma is obtained by the decomposition of the gas within the space between the surface of the conductor of the radio-frequency antenna and a few mm to 1 cm from the surface. In the case of the plasma processing device according to the second aspect of the present invention, since the first reaction gas is supplied into the vicinity of the radio-frequency antenna, the largest amount of the first reaction gas used is decomposed into plasma.
On the other hand, the second reaction gas will be barely decomposed by the radio-frequency electric field since this gas is supplied to a space closer to the substrate holder than the aforementioned space in the vicinity of the radio-frequency antenna. Instead, the second reaction gas is decomposed by the reaction with an H radical, which is a product of the plasma of the first reaction gas, whereby a large amount of radicals that contribute to the deposition of the film are produced.

In the plasma processing devices according to the first and second aspects of the present invention, a gas-passage resistor may be provided at a position between the first reaction gas supply port and the second reaction gas supply port and between the radio-frequency antenna and the second reaction gas supply port. The gas-passage resistor keeps the second reaction gas from coming closer to the radio-frequency antenna, thereby preventing excessive decomposition of the second reaction gas by the electric field from the radio-frequency antenna. It also has the effect of increasing the pressure (density) of the first reaction gas in the vicinity of the radio-frequency antenna and thereby increasing the density of plasma to be generated from the first reaction gas. As the gas-passage resistor, a plate with a large number of holes, a mesh, or similar materials can be used.

In the plasma processing device according to the first aspect of the present invention, the gas-passage resistor may be configured to double as an electrode. This configuration allows a bias voltage to be applied between the gas-passage resistor and the substrate holder so that the ions in the plasma will be more effectively supplied onto the substrate held by the substrate holder. The gas-passage resistor also prevents the generation of unwanted radicals or ions due to an inflow of the second reaction gas on the side of the gas-passage resistor where the radio-frequency antenna is located.

In a desirable mode of the plasma processing devices according to the first and second aspects of the present invention, the radio-frequency antenna is composed of an array of straight conductors arranged parallel to each other. This type of radio-frequency antenna is capable of creating an extremely uniform electromagnetic field in the vicinity thereof.

When the aforementioned straight-conductor antenna is used, the radio-frequency currents supplied to the antenna elements may desirably be generated in such a manner that the currents passing through any two nearest straight-conductor antenna elements flow in phase and in opposite directions. The magnetic fields created in this manner cancel each other at locations distant from the radio-frequency antenna, whereby the generation of unnecessary plasma is prevented.

In a desirable mode of the present invention, the radio-frequency antenna is an electrically conductive first reaction gas tube through which the first reaction gas can be passed, and the first reaction gas supply port is a hole formed in the first reaction gas tube. According to this design, the device structure can be simplified by using the same member as both the radio-frequency antenna and the first reaction gas tube. Furthermore, in the case of the plasma processing device according to the second aspect of the present invention, the use of the hole in the first reaction gas tube, i.e. in the radio-frequency antenna, as the first reaction gas supply port is effective for appropriately supplying the first reaction gas into the vicinity of the radio-frequency antenna.

In the case where a silicon thin film is produced with the plasma processing device according to the first or second aspect of the present invention, it is desirable to supply silane through the second reaction gas supply port. For producing a silicon thin film of a boron-doped p-type semiconductor, it is desirable to supply silane and diborane through the second reaction gas supply port. For producing a silicon thin film of a phosphorus-doped n-type semiconductor, it is desirable to supply silane and phosphine through the second reaction gas supply port. In any of these cases, it is preferable to supply hydrogen through the first reaction gas supply port, whereby the hydrogen gas is sufficiently decomposed into hydrogen ions and electrons in the vicinity of the radio-frequency antenna, forming a high-density hydrogen plasma. Furthermore, a large amount of H radicals are formed through the collision of accelerated electrons with H₂ molecules. When the hydrogen plasma is diffused into the vicinity of the second reaction gas supply port, the hydrogen plasma comes in contact with the second reaction gas and decomposes the molecules of this gas. More specifically, the diffused H radicals cause the following reaction and produce a large amount of SiH₃ radicals:

SiH₄+H⇒SiH₃+H₂.

The ions produced from the first and second reaction gases are appropriately accelerated by the electric field applied by the voltage-applying means and impinge on the surface of the substrate held by the substrate holder, whereby the rearrangement of the radicals and atoms on the surface of the substrate is promoted.

### EFFECTS OF THE INVENTION

In the plasma processing device according to the first aspect of the present invention, the radio-frequency power is focused on the decomposition of the first reaction gas. The second reaction gas, which is supplied into the space between the electrode and the substrate holder located apart from the radio-frequency antenna, will not be excessively decomposed. A bias voltage can be applied between the electrode and the substrate holder so that the ions in the space between the electrode and the substrate holder will gain an appropriate amount of energy and impinge on the substrate held by the substrate holder. As a result, a sufficiently aligned crystalline film can be obtained even if the substrate temperature is low. Excessively decomposed radicals or ions are prevented from reaching the surface of the substrate. The properties of the film are improved due to an ion-assisted surface diffusion which the ions impinging on the substrate contribute to.

In the plasma processing device according to the second aspect of the present invention, the first reaction gas is supplied into a space in the vicinity of the radio-frequency antenna, so that the density of the plasma generated from the first reaction gas is increased. On the other hand, the second reaction gas is prevented from being excessively decomposed by the radio-frequency electromagnetic field created by the radio-frequency antenna since this gas is supplied to a space closer to the substrate holder than the aforementioned space in the vicinity of the radio-frequency antenna.

When the aforementioned gas-passage resistor is used in the plasma processing devices according to the first and second aspects of the present invention, the second reaction gas is more assuredly prevented from reaching the vicinity of the radio-frequency antenna, whereby the second reaction gas is more effectively prevented from being excessively decomposed by the radio-frequency electromagnetic field from the radio-frequency antenna. The gas-passage resistor also increases the density of the first reaction gas in the vicinity of the radio-frequency antenna and thereby increases the density of the plasma generated from the first reaction gas.

### BRIEF DESCRIPTION OF THE DRAWINGS

Fig. 1 is (a) a horizontal-sectional view and (b) A-A' vertical-sectional view of the first embodiment of the plasma processing device according to the present invention.
Fig. 2 is a vertical-sectional view at line B-B' of the plasma processing device 10 of the first embodiment.
Fig. 3 is a C-C' vertical-sectional view of the plasma processing device 10 of the first embodiment.
Fig. 4 is (a) a vertical-sectional view, (b) D-D' horizontal-sectional view and (c) E-E' horizontal-sectional view of the second embodiment of the plasma processing device according to the present invention.
Fig. 5 is a vertical-sectional view of the radio-frequency antenna and the first reaction gas supply ports in the third embodiment of the plasma processing device according to the present invention.
Fig. 6 is (a) a horizontal-sectional view and (b) F-F' vertical-sectional view of the fourth embodiment of the plasma processing device according to the present invention.
Fig. 7 is a G-G' vertical-sectional view of the plasma processing device 10B of the fourth embodiment.
Fig. 8 is a horizontal-sectional view of the radio-frequency antenna and the first reaction gas supply ports in the fifth embodiment of the plasma processing device according to the present invention.
Fig. 9 is a horizontal-sectional view of one variation of the plasma processing device shown in Fig. 8.
Fig. 10 is a horizontal-sectional view of another variation of the plasma processing device shown in Fig. 8.

### BEST MODE FOR CARRYING OUT THE INVENTION

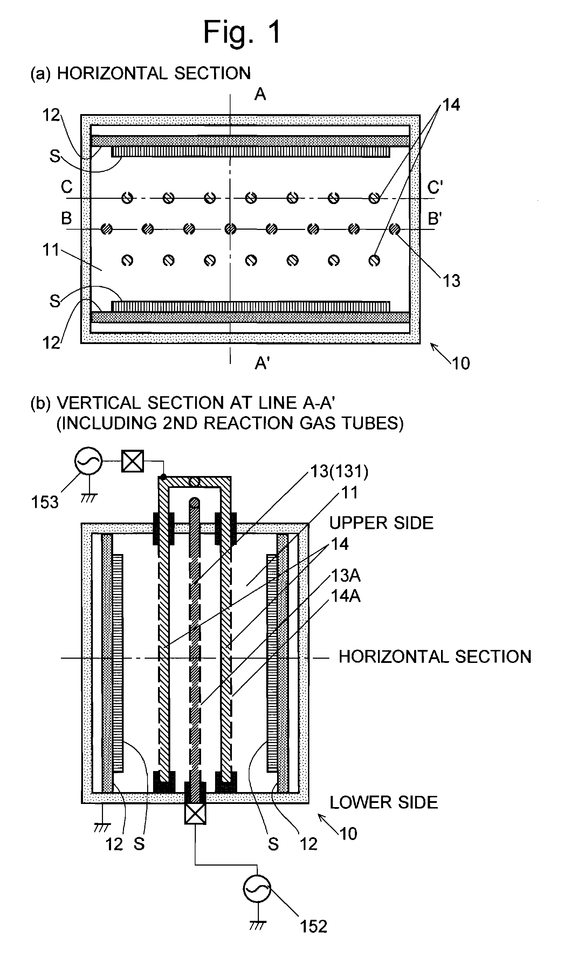

Embodiments of the plasma processing device according to the present invention are hereinafter described by means of Figs. 1-10.

### FIRST EMBODIMENT

Figs. 1-3 show a plasma processing device 10 of the first embodiment, where Fig. 1(a) is a horizontal-sectional view of the device, while Figs. 1(b), 2 and 3 are vertical-sectional views at different positions of the device.
The plasma processing device 10 includes a plasma processing chamber 11 consisting of a vacuum container, a pair of substrate holders 12 standing opposite to each other in the plasma processing chamber 11, a plurality of first reaction gas tubes 13 provided between the two substrate holders 12, and a plurality of second reaction gas tubes 14 provided between the plurality of first reaction gas tubes 13 and each of the two substrate holders 12.

The substrate holders 12 are connected to a ground via the wall surface of the plasma processing chamber 11. Each of the substrate holders 12 has a built-in heater for heating a substrate S held thereon.

The first reaction gas tubes 13, with a plurality of first reaction gas supply ports (holes) 13A formed on the surface thereof, are used for supplying a first reaction gas into the plasma processing chamber 11. Each of the first reaction gas tubes 13 consists of a straight tube, and the plurality of first reaction gas tubes 13 are arrayed parallel to each other. The second reaction gas tubes 14, with a plurality of second reaction gas supply ports (holes) 14A formed on the side facing the substrate holder 12 (in the direction away from the first reaction gas tubes 13), are used for supplying a second gas into the space between the second reaction gas tubes 14 and each of the substrate holders 12.

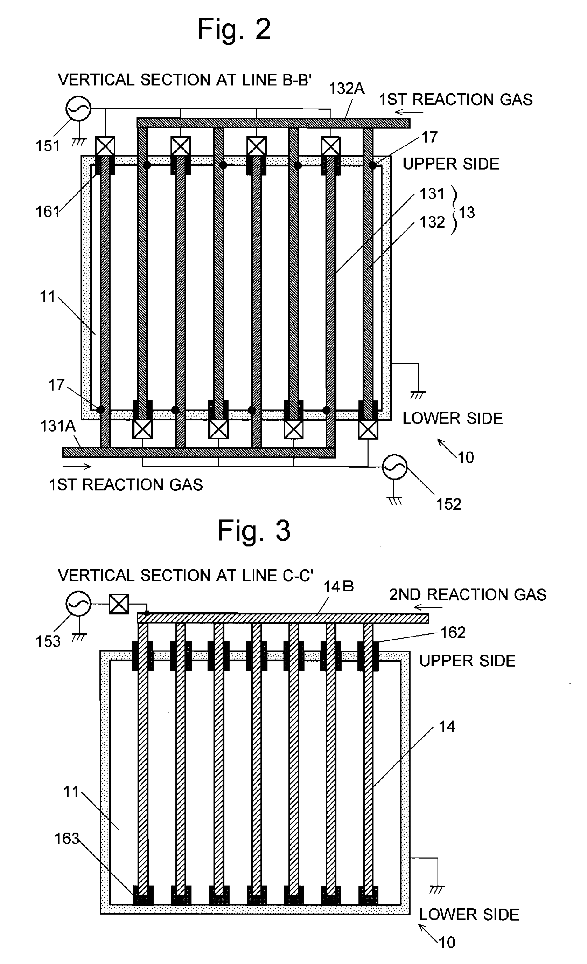

The first reaction gas tubes 13, which are made of an electrically conductive material, are electrically connected, via a matching box, to either a first radio-frequency power source 151 or second radio-frequency power source 152 alternately in order of arrangement within the plasma processing chamber 11. Among the first reaction gas tubes 13, the tubes connected to the first radio-frequency power source 151 are hereinafter referred to as the gas tubes 131, and the tubes connected to the second radio-frequency power source 152 are referred to as the gas tubes 132 (Fig. 2). The gas tubes 131 have their upper ends connected to the first radio-frequency power source 151, while the gas tubes 131 have their lower ends connected to the second radio-frequency power source 152.

Each of the gas tubes 131 and 132 penetrates through both the upper and lower walls of the plasma processing chamber 11. The lower ends of the gas tubes 131 protruding from the lower wall of the plasma processing chamber 11 are connected by a connector tube 131A. Similarly, the upper ends of the gas tubes 132 protruding from the upper wall of the plasma processing chamber 11 are connected by a connector tube 132A. Each gas tube 131 and the upper wall of the plasma processing chamber 11 (i.e. the wall on the side closer to the first radio-frequency power source 151), as well as each gas tube 132 and the lower wall of the plasma processing chamber 11 (i.e. the wall on the side closer to the second radio-frequency power source 152), are separated by a first insulating member 161. On the other hand, the gas tubes 131 and the lower wall of the plasma processing chamber 11, as well as the gas tubes 132 and the upper wall of the plasma processing chamber 11, are electrically connected. The dots 17 in Fig. 2 indicate the electrical connection between the gas tubes 131, 132 and the walls of the plasma processing chamber 11. Since the walls of the plasma processing chamber 11 are electrically conductive and connected to ground, the first reaction gas tubes 13 function as a radio-frequency antenna through which a radio-frequency current passes.

The second reaction gas tubes 14, which are made of an electrically conductive material, are electrically connected to an AC bias power source 153 via a matching box. Each of the second reaction gas tubes 14 penetrates the upper wall of the plasma processing chamber 11 at a portion near the upper end thereof. The second reaction gas tubes 14 are connected to each other, at their upper ends protruding from the upper wall of the plasma processing chamber 11, by a connector tube 14B. A second insulating member 162 is provided between each second reaction gas tube 14 and the upper wall of the plasma processing chamber 11. Similarly, a third insulating member 163 is provided between each second reaction gas tube 14 and the lower wall of the plasma processing chamber 11. This configuration enables the second reaction gas tubes 14 to function as an electrode for applying a bias voltage between these tubes and the substrate holders 12.

Thus, the first reaction gas tubes 13 double as the radio-frequency antenna, and the second reaction gas tubes 14 double as the electrode, whereby the device configuration is simplified.

As one example of the operation of the plasma processing device 10 of the present embodiment, a process of producing a silicon thin film on a substrate S is hereinafter described. Initially, a substrate S is attached to each of the two substrate holders 12. Each substrate S is tightly held on the substrate holder 12. Thus, the two substrates S are maintained in the standing position, without warping, within the plasma processing chamber 11. Next, hydrogen gas (the first reaction gas) is passed through the first reaction gas tubes 13 to supply the hydrogen gas from the first reaction gas supply ports 13A into the vicinity of the first reaction gas tubes 13. Meanwhile, silane gas (the second reaction gas) is passed through the second reaction gas tubes 14 to supply the silane gas from the second reaction gas supply ports 14A into the space between the second reaction gas tubes 14 and the substrate holders 12.

Subsequently, radio-frequency currents are supplied from the first and second radio-frequency power sources 151 and 152 to the first reaction gas tubes 13. Simultaneously, an AC bias voltage is applied between the second reaction gas tubes 14 and the substrate holders 12 by the AC bias power source 153. The radio-frequency currents supplied to the first reaction gas tubes 13 induces an electric field in the vicinity of the first reaction gas tubes 13, whereby the molecules of the hydrogen gas supplied into the vicinity of the first reaction gas tubes 13 are decomposed into ions and electrons. Thus, hydrogen plasma is generated. The resultant hydrogen plasma diffuses within the plasma processing chamber 11 and passes through the interspaces of the second reaction gas tubes 14. In the space between the second reaction gas tubes 14 and the substrate holder 12, hydrogen radicals come in contact with the silane-gas molecules, whereby SiH₃ radicals are generated. During this process, the silane gas will not be excessively decomposed by the electric field formed by the change in the induced electromagnetic field since the space into which the silane gas is supplied is distant from the first reaction gas tubes 13.

The SiH₃ radicals generated in this manner reach the substrate and adhere to its surface, without diffusing within the plasma processing chamber 11. Meanwhile, the hydrogen ions existing in the space between the second reaction gas tubes 14 and the substrate holder 12 are accelerated by the bias electric field with an appropriate strength and collide with the surface of the substrate S, whereby the rearrangement of the SiH₃ radicals Si atoms on the surface of the substrate S is promoted. Thus, a high-quality silicon thin film with only a small amount of atomic defect can be formed.

While the silicon thin film is being formed, the substrate S is heated by the built-in heater of the substrate holder to promote the surface diffusion of the silicon atoms so that an even more uniform film will be formed. Without any ions impinging on the substrate, it would be necessary to maintain the substrate at high temperatures. Making appropriately accelerated ions impinge on the surface of the substrate lowers the temperature required for rearranging the atoms and radicals, thereby providing a wider range of choices of the substrate.

In the plasma processing device 10 of the present embodiment, the first reaction gas is supplied into the vicinity of the first reaction gas tubes 13 and sufficiently decomposed by the high electric field and high magnetic field created with the radio-frequency antenna, whereby high-density plasma is generated. By contrast, the second reaction gas is supplied into the space between the second reaction gas tubes 14 and the substrate holder 12. Since this space is located apart from the first reaction gas tubes 13, the second reaction gas will not be excessively decomposed by the high electric field from the radio-frequency antenna, so that it can come in contact with the plasma generated from the first reaction gas (which is hydrogen plasma in the first embodiment) and form the desired plasma.

Since the second reaction gas tubes 14 are located between the first reaction gas tubes 13 and the substrate holders 12, the second reaction gas is prevented from being decomposed by the high electric field in the vicinity of the first reaction gas tubes 13. Thus, the formation of radicals that can cause second-order reactions is prevented.

In the present embodiment, when currents are supplied from the first and second radio-frequency power sources 151 and 152, it is desirable to make these power sources operate in phase. This operation produces two oppositely directed currents, one current flowing in the gas tubes 131 connected to the first radio-frequency power source 151 and the other flowing in the gas tubes 132 connected to the second radio-frequency power source 152. The magnetic fields generated in this manner cancel each other in the space where the silane gas is supplied, because this space is distant from the first reaction gas tubes 13. Therefore, the silane gas will not be excessively decomposed by the electric field.

### SECOND EMBODIMENT

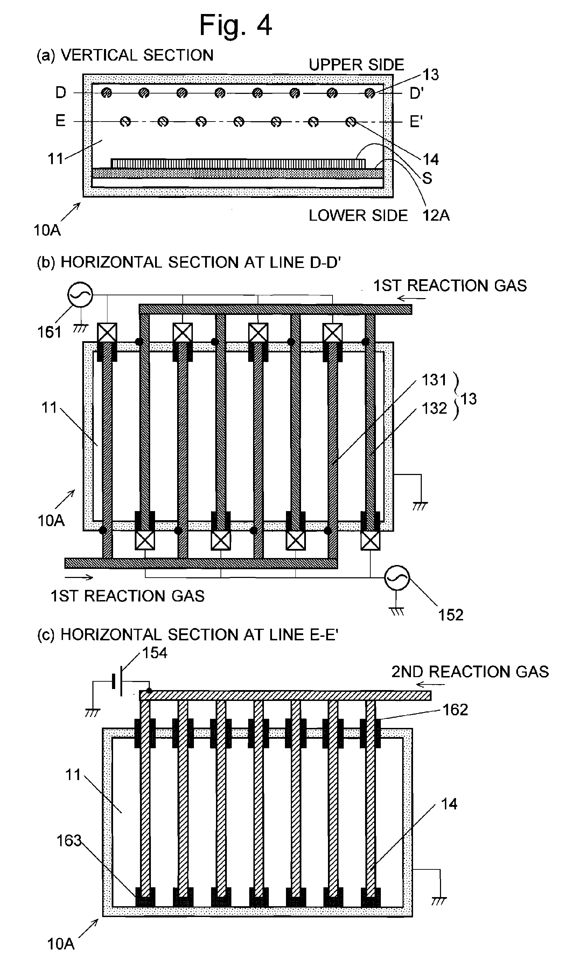

The second embodiment of the plasma processing device according to the present invention is hereinafter described by means of Fig.4. The plasma processing device 10A of the second embodiment has one substrate holder 12A for holding a substrate S in a substantially horizontal position within the plasma processing chamber 11. The substrate S is placed on the substrate holder 12A. There is only one set of the second reaction gas tubes (electrodes) 14 in accordance with the number of the substrate holder 12A. A DC bias voltage 154 is connected to the second reaction gas tubes 14. Other than these points, the plasma processing device 10A of the second embodiment has the same configuration as the plasma processing device 10 of the first embodiment. The operation of the plasma processing device 10A of the second embodiment is also identical to that of the plasma processing device 10 of the first embodiment.

### THIRD EMBODIMENT

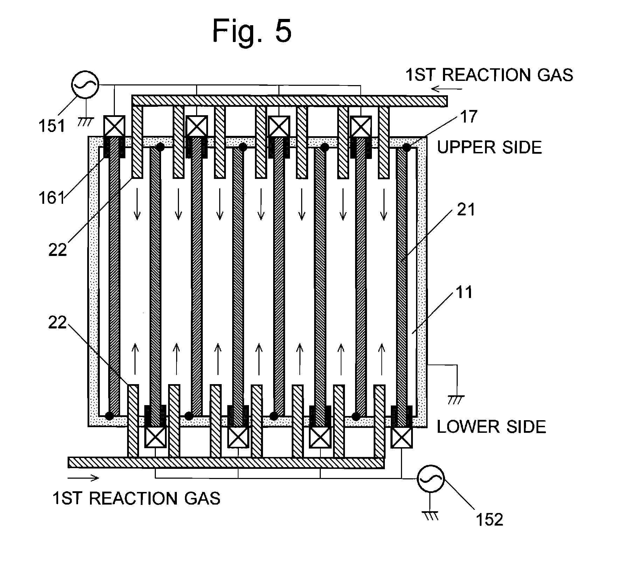

The third embodiment of the plasma processing device according to the present invention is hereinafter described by means of Fig. 5. In the plasma processing device of the third embodiment, radio-frequency antenna 21 is provided independently of the first reaction gas tubes 22. More specifically, the radio-frequency antenna 21 consists of an array of straight conductive rods extending in the vertical direction. A plurality of radio-frequency antenna rods are arrayed parallel to each other within the plasma processing chamber 11. The radio-frequency antenna rods are connected to either the first radio-frequency power source 151 or the second radio-frequency power source 152 alternately in order of arrangement so that the two electric currents flow in opposite directions. The first reaction gas tubes 22 are installed in both the upper and lower walls of the plasma processing chamber 11, with their open ends located inside the plasma processing chamber 11. Each of the first reaction gas tubes 22 is located between the two neighboring radio-frequency antenna rods. Due to such an arrangement of the radio-frequency antenna 21 and the first reaction gas tubes 22, the first reaction gas is supplied into the vicinity of the radio-frequency antenna 21.

### FOURTH EMBODIMENT

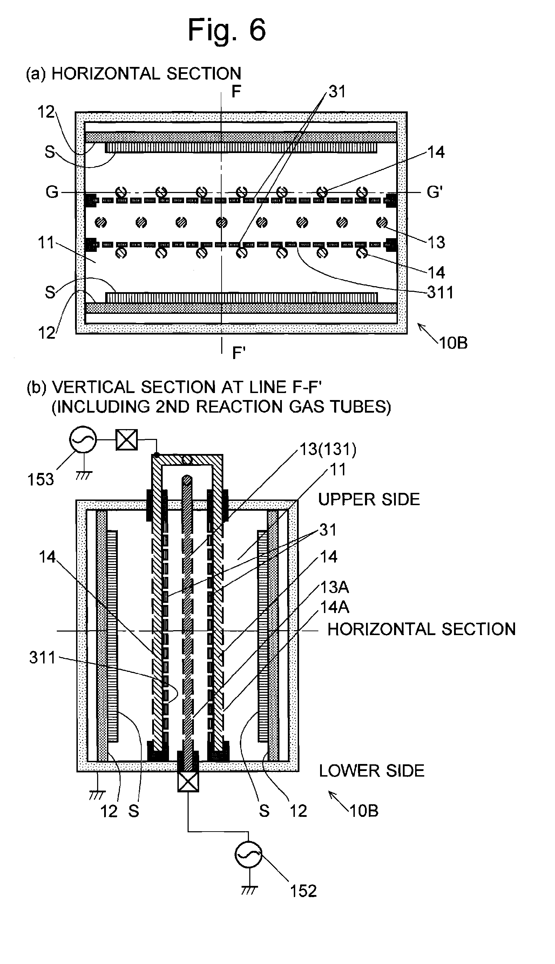

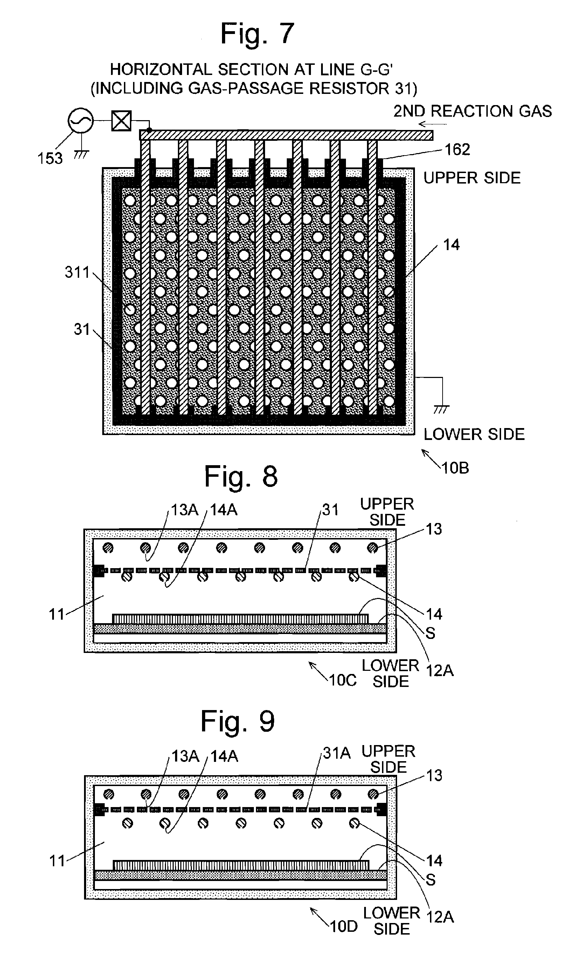

The fourth embodiment of the plasma processing device according to the present invention is hereinafter described by means of Figs. 6 and 7. The plasma processing device 10B of the fourth embodiment differs from the plasma processing device 10 of the first embodiment in that a gas-passage resistor 31 is provided between the first reaction gas tubes 13 and the second reaction gas tubes 14. The gas-passage resistor 31 consists of an electrically conductive plate with a large number of holes 311. The gas-passage resistor 31 is in contact with the second reaction gas tubes 14 and thereby electrically connected to these tubes 14. Therefore, the gas-passage resistor 31 can function as an electrode. The gas-passage resistor 31 is electrically insulated from the walls of the plasma processing chamber 11. The components other than the gas-passage resistor 31 are identical to those used in the first embodiment.

An operation of the plasma processing device 10B of the fourth embodiment is hereinafter described. Initially, a substrate S is attached to each of the substrate holders 12. Next, a first reaction gas is supplied from the first reaction gas supply ports 13A into the vicinity of the first reaction gas tubes 13. Meanwhile, a second reaction gas is supplied from the second reaction gas supply ports 14A into the space between the second reaction gas tubes 14 and each of the substrate holders 12. A radio-frequency current is passed from the first and second radio-frequency power sources 151 and 152 through the first reaction gas tubes 13, whereby an electric field is induced, decomposing the molecules of the first reaction gas in the vicinity of the first reaction gas tubes 13. Thus, plasma is generated. This plasma passes through the gas-passage resistor 31 and comes in contact with the molecules of the second reaction gas, whereby the molecules of the second reaction gas are decomposed into radicals. The resultant radicals of the second reaction gas reach the surface of the substrate S and contribute to the formation of the film on the substrate S.

Additionally, similar to the first embodiment, an appropriate amount of AC bias voltage can be applied between the substrate holders 12 and the second reaction gas tubes 14 (and the gas-passage resistors 31) by the AC bias power source 153 to give an appropriate amount of energy to the ions in the plasma and make them impinge on the substrate S.

In the present embodiment, the gas-passage resistor 31 located between the first reaction gas supply ports 13A and the second reaction gas supply ports 14A prevents mixture of the first and second reaction gases. In particular, it prevents the second reaction gas from flowing into the space near the first reaction gas tubes 13 and being excessively decomposed. To more assuredly prevent the second reaction gas from flowing into the space near the first reaction gas tubes 13, it is desirable to control the supply rates of the first and second reaction gases so that the pressure of the first reaction gas on one side of the gas-passage resistor 31 facing the first reaction gas tubes 13 will be higher than the pressure of the second reaction gas on the other side of the gas-passage resistor 31 facing the second reaction gas tubes 14.

Figs. 8-10 show other examples of the plasma processing devices using the gas-passage resistor 31.
The plasma processing device 10C shown in Fig. 8 is a variation of the device 10A of the second embodiment, in which an electrically conductive gas-passage resistor 31 is provided between the first reaction gas supply ports 13A and the second reaction gas supply ports 14A. In this example, the gas-passage resistor 31 is electrically connected to the second reaction gas tubes 14. This means that the gas-passage resistor 31 additionally functions as an electrode for applying a bias voltage between the substrate holder 12A and itself.

The plasma processing device 10D shown in Fig. 9 is another variation of the device 10A of the second embodiment, in which a gas-passage resistor 31A is provided between the first reaction gas supply ports 13A and the second reaction gas supply ports 14A. A difference from the device 10C shown in Fig. 8 exists in that the gas-passage resistor 13A is isolated from the second reaction gas tubes 14. Accordingly, the second reaction gas tubes 14 solely function as the electrode for applying the bias voltage.

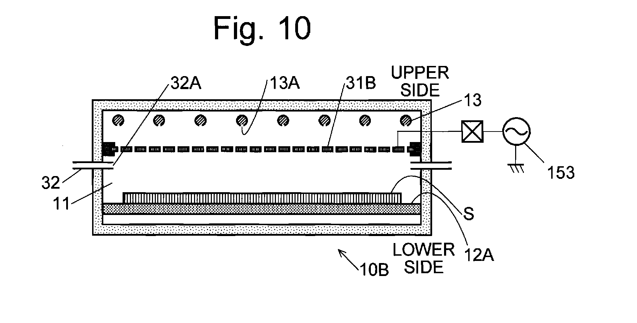

The plasma processing device 10E shown in Fig. 10 differs from the second embodiment in that the second reaction gas tubes 32 penetrate through the side wall of the plasma processing chamber 11. The ends of the second reaction gas tubes 32 protruding into the plasma processing chamber 11 are made to be open, thus forming the second reaction gas supply ports 32A. An electrically conductive gas-passage resistor 31B is provided between the first reaction gas supply ports 13A and the second reaction gas supply ports 32A. In the present example, the AC bias power source 153 is not connected to the second reaction gas 32 but to the gas-passage resistor 31B.

The plasma processing devices shown in Figs. 8-10 operate in the same manner as the plasma processing device 10A of the second embodiment except for the electrode to which the bias voltage is applied and the location where the second reaction gas is introduced.

### EXPLANATION OF NUMERALS

10, 10A, 10B, 10C, 10D, 10E... Plasma Processing Device
11... Plasma Processing Chamber
12, 12A... Substrate Holder
13... First Reaction Gas Tube (Radio-Frequency Antenna)
131... First Reaction Gas Tube Connected to First Radio-Frequency Power Source 151
132... First Reaction Gas Tube Connected to Second Radio-Frequency Power Source 152
13A... First Reaction Gas Supply Port (Hole)
14... Second Reaction Gas Tube (Electrode)
14A... Second Reaction Gas Supply Port (Hole)
151... First Radio-Frequency Power Source
152... Second Radio-Frequency Power Source
153... AC Bias Power Source
154... DC Bias Power Source
161... First Insulating Member
162... Second Insulating Member
163 ... Third Insulating Member
21... Radio-Frequency Antenna
22... First Reaction Gas Tube
31, 31A, 31B... Gas-Passage Resistor
311... Holes Formed in Gas-Passage Resistor
32... Second Reaction Gas Tube
32A... Second Reaction Gas Supply Port of Second Reaction Gas Tube 32

## Claims

1. A plasma processing device, comprising:
a) a plasma processing chamber;
b) a substrate holder provided in the plasma processing chamber;
c) a radio-frequency antenna located apart from the substrate holder within the plasma processing chamber;
d) an electrode located between the radio-frequency antenna and the substrate holder, the electrode being capable of allowing a passage of plasma;
e) a voltage-applying means for applying a voltage between the electrode and the substrate holder;
f) a first reaction gas supply port for supplying a first reaction gas to a space on one side of the electrode where the radio-frequency antenna is located; and
g) a second reaction gas supply port for supplying a second reaction gas into a space between the electrode and the substrate holder.

2. The plasma processing device according to claim 1, wherein the electrode is an array of electrically conductive second reaction gas tubes through which the second reaction gas can be passed, and the second reaction gas supply port is a hole formed in the second reaction gas tube.

3. The plasma processing device according to claim 1 or 2, further comprising a gas-passage resistor at a position between the first reaction gas supply port and the second reaction gas supply port and between the radio-frequency antenna and the second reaction gas supply port.

4. The plasma processing device according to claim 3, wherein the gas-passage resistor doubles as an electrode.

5. A plasma processing device, comprising:
a) a plasma processing chamber;
b) a substrate holder provided in the plasma processing chamber;
c) a radio-frequency antenna located apart from the substrate holder within the plasma processing chamber;
d) a first reaction gas supply port for supplying a first reaction gas to a space in a vicinity of the radio-frequency antenna; and
e) a second reaction gas supply port for supplying a second reaction gas to a space closer to the substrate holder than the aforementioned space in the vicinity of the radio-frequency antenna.

6. The plasma processing device according to claim 5, further comprising a gas-passage resistor at a position between the first reaction gas supply port and the second reaction gas supply port and between the radio-frequency antenna and the second reaction gas supply port.

7. The plasma processing device according to one of claims 3, 4 and 6, wherein the gas-passage resistor is a plate with a large number of holes.

8. The plasma processing device according to one of claims 1-7, wherein the radio-frequency antenna is an electrically conductive first reaction gas tube through which the first reaction gas can be passed, and the first reaction gas supply port is a hole formed in the first reaction gas tube.

9. The plasma processing device according to one of claims 1-8, wherein the radio-frequency antenna is an array of straight conductors arranged parallel to each other.

10. The plasma processing device according to claim 9, radio-frequency currents supplied to the straight-conductor antenna are generated in such a manner that the currents passing through any two nearest straight-conductor antenna elements flow in phase and in opposite directions.

11. The plasma processing device according to one of claims 1-10, wherein hydrogen is supplied through the first reaction gas supply port, and either silane, a combination of silane and diborane, or a combination of silane and phosphine is supplied through the second reaction gas supply port.
